Europäisches Patentamt

European Patent Office

Office européen des brevets

(19)

(11) Numéro de publication : **0 177 422 B1**

(12) # FASCICULE DE BREVET EUROPÉEN

(45) Date de publication du fascicule du brevet :
30.11.88

(51) Int. Cl.⁴ : **H 01 L 21/28**, H 01 L 21/00, H 01 L 21/82

(21) Numéro de dépôt : **85401912.2**

(22) Date de dépôt : **01.10.85**

(54) **Procédé de réalisation de grilles en siliciure ou en silicium pour circuit intégré comportant des éléments du type grille-isolant-semiconducteur.**

(30) Priorité : **02.10.84 FR 8415125**

(43) Date de publication de la demande :
**09.04.86 Bulletin 86/15**

(45) Mention de la délivrance du brevet :
**30.11.88 Bulletin 88/48**

(84) Etats contractants désignés :
**DE GB NL**

(56) Documents cités :
**EP-A- 0 075 085**
**US-A- 4 470 189**

(73) Titulaire : **THOMSON-CSF**
**173, Boulevard Haussmann**
**F-75379 Paris Cedex 08 (FR)**

(72) Inventeur : **Blanchard, Pierre**
**THOMSON-CSF SCPI 173, bld Haussmann**
**F-75379 Paris Cedex 08 (FR)**
Inventeur : **Cortot, Jean-Paul**
**THOMSON-CSF SCPI 173, bld Haussmann**
**F-75379 Paris Cedex 08 (FR)**

(74) Mandataire : **Ruellan-Lemonnier, Brigitte et al**
**THOMSON-CSF SCPI 19, avenue de Messine**
**F-75008 Paris (FR)**

EP 0 177 422 B1

Jouve, 18, rue St-Denis, 75001 Paris, France

## Description

La présente invention concerne un procédé de réalisation de grilles en siliciure ou en silicium pour circuit intégré comportant des éléments du type grille-isolant-semiconducteur. Elle concerne, en particulier, un nouveau procédé permettant d'obtenir un espacement entre grilles très faible, ce qui donne des circuits intégrés, notamment des dispositifs à transfert de charge ou des circuits utilisant des éléments de type MOS (métal-oxyde-semiconducteur), très compacts.

Dans les circuits ci-dessus, les grilles sont réalisées en un matériau conducteur qui peut être, par exemple, un métal tel que l'aluminium, un métalloïde tel que du silicium polycristallin fortement dopé ou formé d'une double couche de silicium polycristallin fortement dopé recouvert d'un siliciure. Pour réaliser notamment les grilles en silicium polycristallin ou les grilles a double couche silicium polycristallin-siliciure, on utilise la technique habituelle de photolithogravure. Ainsi, selon un des procédés habituels, pour réaliser des grilles à double couche silicium polycristallin-siliciure, après avoir délimité les éléments du circuit en ouvrant des fenêtres dans une couche d'isolant épais recouvrant le substrat semiconducteur et déposé une couche mince d'isolant, on dépose sur l'ensemble du circuit une couche de silicium polycristallin que l'on recouvre d'une couche d'un métal donnant un siliciure. Puis par masquage, insolation, développement et gravure, on délimite les grilles. On soumet ensuite l'ensemble à un recuit dans une atmosphère neutre pour transformer la couche métallique au contact du silicium polycristallin en siliciure. Ce procédé est très simple. Toutefois, il ne permet pas l'obtention d'un espacement entre grilles inférieur à 2,5 μm.

La présente invention a pour but de remédier à cet inconvénient en fournissant un nouveau procédé de réalisation de grilles en silicium pour circuit intégré comportant des éléments du type grille-isolant-semiconducteur permettant d'avoir un espacement entre grilles inférieur à 1 μm.

Ainsi, la présente invention a pour objet un procédé de réalisation de grilles en silicium pour circuit intégré comportant des éléments du type grille-isolant-semiconducteur, caractérisé par les étapes suivantes :
- dépôt successif, sur l'isolant recouvrant le semiconducteur, d'une couche de silicium polycristallin convenablement dopé, d'une couche de métal donnant un siliciure, d'une couche d'oxyde et d'une couche de masquage,
- réalisation, de manière connue, d'ouvertures dans la couche de masquage,
- réalisation, au niveau des ouvertures, d'un surplomb sous la couche de masquage par élimination de la couche d'oxyde sur une certaine longueur,
- élimination de la couche métallique délimitée par le surplomb,
- dépôt, dans les ouvertures, d'une nouvelle couche de métal donnant un siliciure,
- recuit de l'ensemble du circuit dans une atmosphère neutre pour transformer les parties ou la couche de métal est en contact avec la couche de silicium polycristallin, en siliciure,
- élimination des couches recouvrant les parties en siliciure, puis,
- élimination du silicium polycristallin entre les parties en siliciure pour délimiter les grilles.

Avec ce procédé, on peut contrôler très efficacement la longueur du surplomb qui détermine en fait l'espacement entre grilles comme expliqué de manière plus détaillée ci-après. En effet, le surplomb est obtenu par désoxydation de la couche d'oxyde et la longueur sur laquelle se produit cette désoxydation est fonction de l'épaisseur de la couche d'oxyde et du temps de désoxydation. Ainsi, en contrôlant ces deux paramètres, on contrôle la longueur du surplomb et, en conséquence, l'espacement entre grilles.

D'autres caractéristiques et avantages de la présente invention apparaîtront à la lecture de la description d'un mode de réalisation préférentiel faite avec référence au dessin ci-annexé dans lequel :
- les figures 1a à 1e représentent schématiquement les différentes étapes du procédé de réalisation de grilles en silicium conforme à la présente invention, et
- les figures 2a et 2b représentent schématiquement un circuit à deux niveaux de grilles obtenu respectivement selon un procédé de l'art antérieur et selon le procédé de la présente invention.

Sur les figures, les mêmes références désignent les mêmes éléments, mais pour des raisons de clarté, les cotes et proportions des divers éléments ne sont pas respectées.

Conformément au procédé de la présente invention, après avoir réalisé sur un substrat semiconducteur 1, en silicium de type p par exemple, une couche mince et continue 2 d'un matériau isolant tel que de l'oxyde de silicium ($SiO_2$), on recouvre cette couche d'oxyde de silicium d'une couche 3 de silicium polycristallin convenablement dopé. De manière typique, le silicium polycristallin est dopé au phosphore.

Sur cette couche 3 de silicium polycristallin, on dépose une couche métallique 4. La couche métallique 4 est réalisée en un métal susceptible de réagir avec le silicium polycristallin pour donner un siliciure. A titre d'exemple, la couche métallique peut être réalisée en tungstène, en molybdène, en titane, en tantale, en chrome, en nickel. Toutefois, elle sera de préférence réalisée en tantale, car le tantale allié au silicium est quasiment inerte aux agents chimiques utilisés lors des autres phases du procédé, en particulier à l'acide fluorhydrique.

Sur la couche métallique, on dépose en phase vapeur une couche 5 d'oxyde. Ce dépôt peut être réalisé à pression atmosphérique ou à basse pression, selon les procédés classiques connus sous les dénominations anglaises « chemical vapor deposition » (CVD) et « low temperature oxydation » (LTO). Ce dépôt est réalisé de préférence à une température inférieure à la température de formation de l'alliage. D'autre part, l'épaisseur de la couche est choisie de manière précise. En effet, comme expliqué ci-après, l'épaisseur de la couche d'oxyde est un des paramètres déterminant l'espacement entre grilles.

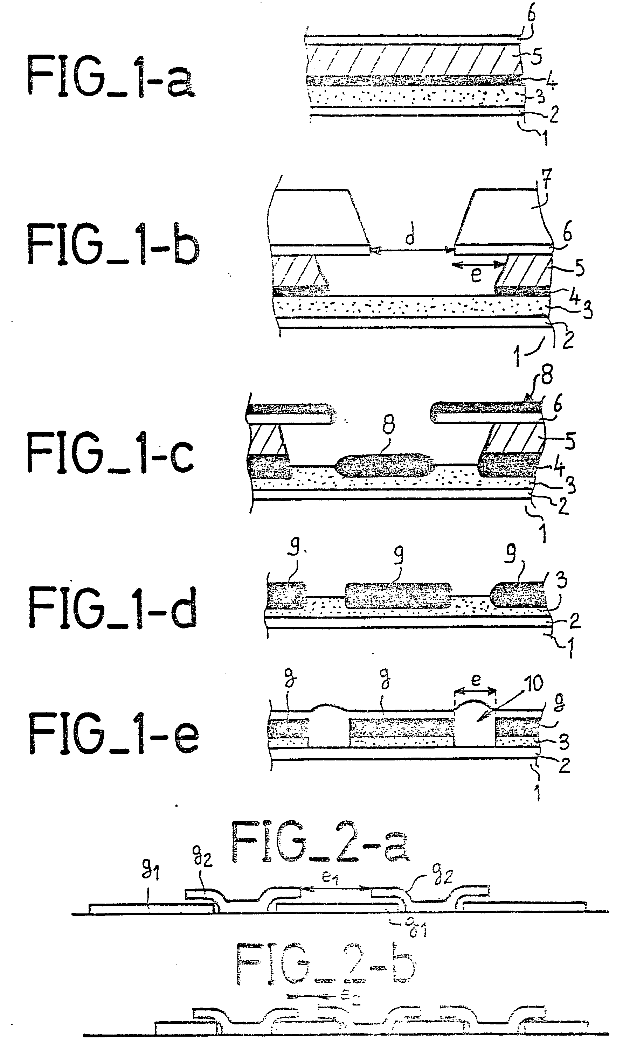

Sur cette couche d'oxyde pyrolytique, on dépose une couche 6 de masquage qui est réalisée de préférence en nitrure de silicium (Si₃N₄). On obtient donc la structure représentée à la figure 1a.

Ensuite, en utilisant la technique connue de photolithogravure, on ouvre dans la couche de masquage 6 des fenêtres dont les dimensions d correspondent à celles des grilles que l'on veut réaliser. Pour cela, de manière connue, on dépose sur la couche 6 de nitrure de silicium une résine 7 photosensible de type positif par exemple. On cuit la résine pour la durcir. Ensuite, on applique sur la résine un masque, chrome sur verre par exemple, ayant pour objet de délimiter les fenêtres à ouvrir.

On insole la résine aux rayons ultraviolets à travers le masque pour la polymériser aux endroits non protégés par le masque puis on développe dans un produit approprié qui dissout la résine polymérisée en laissant subsister la résine non polymérisée. On grave alors la couche 6 de nitrure de silicium pour obtenir les fenêtres d.

On élimine alors la couche 5 d'oxyde pyrolytique de manière à créer un surplomb de longueur e déterminée sous la couche de masquage. Pour cela, on réalise une désoxydation de ladite couche dans une solution d'acide fluorhydrique par exemple qui dissout l'oxyde en laissant intact la couche métallique, notamment lorsque cette couche est en tantale. La désoxydation se produit sur une longueur e qui correspond au moins à l'épaisseur de la couche 6 et qui peut être modulée en fonction du temps de désoxydation.

On élimine alors par gravure la couche de métal se trouvant dans l'ouverture ainsi réalisée comme représenté sur la figure 1b.

Ensuite, on redépose sur l'ensemble du circuit une nouvelle couche 8 du métal donnant un siliciure. Cette couche se dépose sur le silicium polycristallin dans l'ouverture sur une distance d comme représenté sur la figure 1c.

On soumet alors l'ensemble du circuit à un recuit dans une atmosphère neutre, par exemple en argon, pour transformer en siliciure les parties ou la couche métallique 4 et 8 est en contact avec la couche 3 de silicium polycristallin. Le recuit est réalisé de préférence à une température comprise entre 900 °C et 1100 °C en environ 30 minutes.

On élimine ensuite par attaque chimique les différentes couches 5, 6, 8 recouvrant les parties en silicium 9, ce qui donne la structure représentée à la figure 1d.

Puis, on enlève le silicium polycristallin se trouvant entre les parties en silicium de manière à isoler les grilles g. Cette élimination du silicium polycristallin peut être réalisée par gravure sèche ou par oxydation sèche.

Eventuellement, on peut réaliser les grilles uniquement en silicium polycristallin en éliminant la couche 9 de siliciure. Cette élimination est réalisée par gravure. Ce type de grilles est particulièrement intéressant dans le cas des senseurs à photo-mos où les grilles doivent être transparentes.

On recouvre alors éventuellement les grilles d'une couche de passivation 10 comme représenté à la figure 1e.

Ainsi, avec le procédé ci-dessus, il est possible de réaliser des grilles à double couche silicium polycristallin-siliciure ou des grilles en silicium présentant entre elles un espacement e bien défini. Cet espacement n'est plus fonction des techniques de masquage utilisées mais de l'épaisseur de la couche d'oxyde qui peut être contrôlée à des valeurs très faibles et de la précision du temps de désoxydation.

Ce procédé est particulièrement intéressant pour la réalisation de dispositifs à transfert de charge du type CCD (pour Charge Coupled Device en anglais) qui sont constitués de plusieurs ensembles de capacités MIS (Metal Isolant Semiconducteur) juxtaposées formant des capacités de stockage et de transfert.

Avec le procédé de la présente invention, il est possible de réaliser des CCD à un seul niveau de grilles en siliciure plus compacts que les CCD actuellement disponibles. Ainsi on peut réaliser un CCD fonctionnant en trois phases présentant un pas de 9 µm ou un CCD fonctionnant en quatre phases présentant un pas de 12 µm.

Cela permet d'obtenir un gain sur la densité des étages CCD et d'avoir un couplage en phases plus faible.

Le procédé de la présente invention est aussi intéressant dans le cas des CCD à deux niveaux de grilles. En effet, comme représenté sur la figure 2a, l'espacement $e_1$ entre les grilles $g_2$ est d'au moins 2 à 3 µm, car les techniques de photolithogravure habituellement utilisées, pour réaliser le second niveau de grilles ne permettent pas d'avoir un espacement plus faible. D'autre part, le recouvrement de la grille $g_2$ sur la grille $g_1$ est réalisé sur une distance d'au moins 1 µm, ce qui donne pour la grille $g_1$ une largeur d'au moins 4 à 5 µm. Or, comme représenté sur la figure 2b, en utilisant le procédé de la présente invention, il est possible d'obtenir un espacement $e_2$ entre les grilles $g_1$ inférieur à 1 µm. Il est donc possible de réaliser une grille $g_1$ présentant une largeur inférieure à 3 µm.

D'autre part, dans le cas de deux niveaux de grilles, on peut envisager de réaliser le premier niveau de grilles en silicium polycristallin et le deuxième niveau de grilles en siliciure. Ceci est intéressant pour la réalisation de dispositifs photosensibles. Dans ce cas, le premier niveau de grilles est réalisé de préférence en utilisant la technologie connue puisque l'espacement entre grilles. doit être suffisant pour recevoir le deuxième niveau de grilles. Toutefois, après avoir déposé sur le premier niveau de grilles une couche d'isolant, on réalise le second niveau de grilles en siliciure en utilisant le procédé de la présente invention.

**Revendications**

1. Procédé de réalisation de grilles en siliciure pour circuit intégré comportant des éléments du type grille-isolant-semiconducteur, caractérisé par les étapes suivantes :
- dépôt successif, sur l'isolant (2) recouvrant le semiconducteur (1), d'une couche (3) de silicium polycristallin convenablement dopé, d'une couche (4) de métal donnant un siliciure, d'une couche (5) d'oxyde et d'une couche de masquage (6),
- réalisation, de manière connue, d'ouvertures (d) dans la couche de masquage,
- réalisation, au niveau des ouvertures, d'un surplomb sous la couche de masquage par élimination de la couche d'oxyde sur une certaine longueur (e),
- élimination de la couche métallique délimitée par le surplomb,
- dépôt dans les ouvertures d'une nouvelle couche (8) de métal donnant un siliciure,
- recuit de l'ensemble du circuit dans une atmosphère neutre pour transformer les parties ou la couche de métal est en contact avec la couche en silicium polycristallin, en siliciure,
- élimination des couches recouvrant les parties (9) en siliciure, puis
- élimination du silicium polycristallin entre les parties en siliciure pour délimiter les grilles (g).

2. Procédé de réalisation de grilles en siliciure selon la revendication 1, caractérisé en ce que la couche (4, 8) de métal est une couche d'un métal choisi parmi le tantale, le titane, le tungstène, ou le molybdène.

3. Procédé de réalisation de grilles en siliciure selon la revendication 1, caractérisé en ce que la couche (6) de masquage est une couche de nitrure de silicium.

4. Procédé de réalisation de grilles en siliciure selon la revendication 1, caractérisé en ce que le dépôt de la couche (5) d'oxyde est réalisé à une température inférieure à la température de formation de l'alliage.

5. Procédé de réalisation de grilles en siliciure selon la revendication 1, caractérisé en ce que les ouvertures dans la couche de masquage sont réalisées par photolithographie et gravure.

6. Procédé de réalisation de grilles en siliciure selon la revendication 1, caractérisé en ce que l'élimination de la couche d'oxyde est réalisée par désoxydation.

7. Procédé de réalisation de grilles en siliciure selon l'une quelconque des revendications 1 et 6, caractérisé en ce que la longueur (e) du surplomb est déterminée par l'épaisseur de la couche d'oxyde et le temps de désoxydation.

8. Procédé de réalisation de grilles en siliciure selon la revendication 1, caractérisé en ce que le recuit est réalisé à une température comprise entre 900 °C et 1100 °C.

9. Procédé de réalisation de grilles en siliciure selon la revendication 1, caractérisé en ce que le recuit est réalisé sous atmosphère neutre d'argon.

10. Procédé de réalisation de grilles en siliciure caractérisé en ce que, après avoir réalisé un premier niveau de grilles par une technologie connue, on redépose sur le premier niveau de grilles, une couche d'isolant et on réalise un second niveau de grilles en siliciure en utilisant le procédé selon l'une quelconque des revendications 1 à 9.

11. Procédé de réalisation de grilles en siliciure selon la revendication 10, caractérisé en ce que les grilles du premier niveau de grilles sont des grilles en silicium polycristallin convenablement dopé ou des grilles formées d'une double couche silicium polycristallin-siliciure.

12. Procédé de réalisation de grilles en silicium, caractérisé en ce que l'on réalise tout d'abord des grilles en siliciure en utilisant le procédé selon l'une quelconque des revendications 1 à 9 puis on élimine la couche de siliciure.

**Claims**

1. A method of producing silicide gate electrodes for an integrated circuit comprising elements of the gate-insulationsemiconductor type, characterized by the following steps :
- consecutive deposit, on the insulation (2) covering the semiconductor (1), of a layer of conveniently doped polycristalline silicon, of a layer (4) of metal capable of producing a silicide, of an oxide layer (5), and of a masking layer (6),
- providing openings (d) in the masking layer in a known manner,
- providing, at the level of the openings, an overhang under the masking layer by elimination of the oxide layer along a certain length (e),
- eliminating the metal layer delimited by the overhang,
- depositing a new metal layer (3) in the openings capable of producing a silicide,
- annealing the entire circuit in a neutral atmosphere for transforming the portions into silicide, where the metal layer is in contact with the polycristalline silicon layer,
- eliminating the layers covering the silicide portions (9), and,
- eliminating the polycristalline silicon between the silicide portions in order to delimit the gates (g).

2. A method for producing silicide gate electrodes according to claim 1, characterized in that the metal layer (4, 8) is a layer of a metal selected amongst tantalum, titanium, tungsten or molybdenum.

3. A method for producing silicide gate electrodes according to claim 1, characterized in that the resist layer (6) is a layer of silicon nitride.

4. A method for producing silicide gate electrodes according to claim 1, characterized in that depositing of the oxide layer (5) is effected at a lower temperature than the alloy formation temperature.

5. A method for producing silicide gate electrodes according to claim 1, characterized in that the openings in the masking layer are effected by photolithography or engraving.

6. A method for producing silicide gate electrodes according to claim 1, characterized in that the elimination of the oxide layer is effected by desoxidation.

7. A method for producing silicide gate electrodes according to any one of claims 1 and 6, characterized in that the length (e) of the overhang is determined by the thickness of the oxide layer and the desoxidation time.

8. A method for producing silicide gate electrodes according to claim 1, characterized in that the annealing is carried out at a temperature comprised between 900 °C and 1100 °C.

9. A method for producing silicide gate electrodes according to claim 1, characterized in that the annealing is carried out under neutral argon atmosphere.

10. A method for producing silicide gate electrodes, characterized in that after having prepared a first gate level by adopting a known technique, an insulating layer is redeposited on the first gate level, and a second silicide gate level is prepared, adopting the method according to any of the claims 1 to 9.

11. A method for producing silicide gate electrodes according to claim 10, characterized in that the gate electrodes of the first gate level are gates made up of conveniently doped polycristalline silicon or gates consisting of a double polycristalline silicon-silicide layer.

12. A method for producing silicide gate electrodes, characterized in that first of all silicide gate electrodes are prepared by applying a method according to any of the claims 1 to 9, then followed by eliminating the silicide layer.

**Patentansprüche**

1. Verfahren zur Herstellung von Gates aus Silizid für einen integrierten Schaltkreis, der Elemente vom Typ Gate-Isolation-Halbleiter aufweist, gekennzeichnet durch die folgenden Stufen :

- aufeinanderfolgendes Aufbringen einer polykristallinen, passend dotierten Siliciumschicht (3), einer ein Silizid bildenden Metallschicht (4), einer Oxidschicht (5) und einer Maskenschicht (6) auf der den Halbleiter bedeckenden Isolierschicht (2),

- Einbringen von Öffnungen (d) in die Maskenschicht in bekannter Weise,

- Herstellen eines Überhanges in Höhe der Öffnungen unter der Maskenschicht durch Entfernen der Oxidschicht über eine gewisse Länge (e),

- Entfernen der durch den Überhang begrenzten Metallschicht,

- Anbringen einer neuen, ein Silizid bildenden Metallschicht (8),

- Wärmebehandlung des gesamten Schaltkreises in einer neutralen Atmosphäre zur Umwandlung der Bereiche, in denen die Metallschicht mit der polykristallinen Siliciumschicht in Berührung steht, in das Silizid,

- Entfernen der die Bereiche (9) des Silizids bedeckenden Schichten, und

- Entfernen des polykristallinen Siliciums zwischen den Silizidbereichen zur Abgrenzung der Gates (g).

2. Verfahren zur Herstellung von Silizidgates nach Anspruch 1, dadurch gekennzeichnet, daß die Metallschicht (4, 8) eine Schicht aust einem Metall is, das aus der Tantal, Titan, Wolfram oder Molybdän enthaltenden Gruppe ausgewählt ist.

3. Verfahren zur Herstellung von Silizidgates nach Anspruch 1, dadurch gekennzeichnet, daß die Maskenschicht (6) eine Schicht aus Siliciumnitrid ist.

4. Verfahren zur Herstellung von Silizidgates nach Anspruch 1, dadurch gekennzeichnet, daß das Aufbringen der Oxidschicht (5) bei einer Temperatur unterhalb der Legierungstemperatur erfolgt.

5. Verfahren zur Herstellung von Silizidgates nach Anspruch 1, dadurch gekennzeichnet, daß die Öffnungen in der Maskenschicht durch Photolithographie und Gravur erzeugt werden.

6. Verfahren zur Herstellung von Silizidgates nach Anspruch 1, dadurch gekennzeichnet, daß das Entfernen der Oxidschicht durch Desoxidieren erfolgt.

7. Verfahren zur Herstellung von Silizidgates nach einem der Ansprüche 1 und 6, dadurch gekennzeichnet, daß die Länge (e) des Überhangs durch die Dicke der Oxidschicht und die Desoxidationszeit bestimmt ist.

8. Verfahren zur Herstellung von Silizidgates nach Anspruch 1, dadurch gekennzeichnet, daß dis Wärmebehandlung bei einer Temperatur zwischen 900 °C und 1100 °C erfolgt.

9. Verfahren zur Herstellung von Silizidgates nach Anspruch 1, dadurch gekennzeichnet, daß die Wärmebehandlung in neutraler Argonatmosphäre erfolgt.

10. Verfahren zur Herstellung von Silizidgates, dadurch gekennzeichnet, daß nach Herstellung eines ersten Gateniveaus durch eine bekannte Technik auf dem ersten Gateniveau wieder eine Isolierschicht aufgebracht wird, und daß ein zweites Gateniveau aus Silizid unter Anwendung des Verfahrens nach einem beliebigen der Ansprüche 1 bis 9 hergestellt wird.

11. Verfahren zur Herstellung von Silizidgates nach Anspruch 10, dadurch gekennzeichnet, daß die Gates des ersten Gateniveaus aus passend dotiertem, polykristallinem Silicium bestehen oder aus einer Doppelschicht polykristallines Silicium-Silizid gebildet sind.

12. Verfahren zur Herstellung von Silizidgates, dadurch gekennzeichnet, daß zuerst Silizidgates unter Anwendung des Verfahrens nach einem beliebigen der Ansprüche 1 bis 9 hergestellt werden und dann die Silizidschicht enfernt wird.

FIG_1-a

FIG_1-b

FIG_1-c

FIG_1-d

FIG_1-e

FIG_2-a

FIG_2-b